# EUROPÄISCHE PATENTSCHRIFT

(11) **EP 1 977 442 B1**
(45) Veröffentlichungstag und Bekanntmachung des Hinweises auf die Patenterteilung: **23.11.2011**
(21) Anmeldenummer: 07702893.4
(22) Anmeldetag: 19.01.2007
(51) Int. Cl.: H01L 21/225, H01L 27/142, H01L 31/0224

(54) **VERFAHREN ZUR HERSTELLUNG EINES HALBLEITERBAUELEMENTS MIT UNTERSCHIEDLICH STARK DOTIERTEN BEREICHEN**
METHOD FOR FABRICATING A SEMICONDUCTOR COMPONENT HAVING REGIONS WITH DIFFERENT LEVELS OF DOPING
PROCÉDÉ DE FABRICATION D'UN COMPOSANT SEMI-CONDUCTEUR AVEC DES ZONES DOPÉES À DES DEGRÉS DIFFÉREMMENT FORTS

(30) Priorität: 23.01.2006 DE 102006003283
(43) Veröffentlichungstag der Anmeldung: 08.10.2008
(73) Patentinhaber: GP Solar GmbH, 78467 Konstanz (DE)
(72) Erfinder: FATH, Peter, 78464 Konstanz (DE); MELNYK, Ihor, 78465 Konstanz (DE)
(74) Vertreter: Heyerhoff & Geiger
(86) Internationale Anmeldenummer: PCT/EP2007/000463
(87) Internationale Veröffentlichungsnummer: WO 2007/082760

(56) Entgegenhaltungen:
- WO-A-01/24279
- GB-A- 1 172 491
- US-A- 3 541 678
- US-A- 4 152 824
- US-A1- 2005 172 996
- YEROKHOV V YU ET AL: "Photoconversion in solar cell structures with porous silicon" PROCEEDINGS OF THE SPIE - THE INTERNATIONAL SOCIETY FOR OPTICAL ENGINEERING SPIE-INT. SOC. OPT. ENG USA, Bd. 3580, 1998, Seiten 168-177, XP002428596 ISSN: 0277-786X
- RALPH KUHN ET AL: "Characterization of Novel Mono- and Bifacially Active Semi-Transparent Crystalline Silicon Solar Cells" IEEE TRANSACTIONS ON ELECTRON DEVICES, IEEE SERVICE CENTER, PISACATAWAY, NJ, US, Bd. 46, Nr. 10, Oktober 1999 (1999-10), XP011017052 ISSN: 0018-9383
- YEROKHOV V Y ET AL: "Porous silicon in solar cell structures: a review of achievements and modern directions of further use" RENEWABLE AND SUSTAINABLE ENERGY REVIEWS, ELSEVIERS SCIENCE, NEW YORK, NY, US, Bd. 3, Nr. 4, Dezember 1999 (1999-12), Seiten 291-322, XP004268410 ISSN: 1364-0321

## Beschreibung

Verfahren zur Herstellung eines Halbleiterbauelements mit unterschiedlich stark dotierten Bereichen

Die Erfindung betrifft ein Verfahren zur Herstellung eines Halbleiterbauelements, insbesondere einer Solarzelle, mit unterschiedlich stark dotierten Bereichen sowie dessen Verwendung in integrierten Schaltungen, elektronischen Schaltungen, Solarzellenmodulen sowie zur Herstellung von Solarzellen mit selektiver Emitterstruktur.

Bei der Herstellung vieler Halbleiterbauelemente ist es erforderlich, Bereiche mit unterschiedlich starker Dotierung vorzusehen, wobei unter Halbleiterbauelementen im Sinne dieser Patentanmeldung nicht nur kommerziell eingesetzte elektronische Bauelemente verstanden werden, sondern auch Halbfabrikate und dotierte Halbleiterstrukturen. Im Extremfall also auch ein Halbleiter, der lediglich unterschiedlich dotierte Bereiche aufweist.

Beispielsweise werden bei der Herstellung von Solarzellen Bereiche unterschiedlich starker Dotierung vorgesehen, um auf diese Weise eine Emitterstruktur auszubilden, welche in gewissen Bereichen auf einer starken Dotierung, in den übrigen Bereichen auf einer schwachen Dotierung beruht. Mit dieser so genannten selektiven Emitterstruktur, bei welcher üblicherweise auf den hoch dotierten Bereichen Metallkontakte ausgebildet werden, lässt sich bekanntermaßen eine effiziente Stromabfuhr bei gleichzeitig geringer Ladungsträgerrekombination in den übrigen schwach dotierten Bereichen realisieren.

Verfahren zur Herstellung selektiver Emitterstrukturen sind beispielsweise aus US 4,152,824 bekannt. Unter anderem wird ein Verfahren offenbart, bei welchem eine undotierte Siliziumoxidschicht als diffusionhemmende Schicht verwendet wird. Dieses Verfahren ist jedoch zeit- und kostenintensiv.

Der vorliegenden Erfindung liegt daher das Problem zu Grunde, ein einfaches und aufwandsgünstiges Verfahren zur Herstellung eines Halbleiterbauelements mit unterschiedlich stark dotierten Bereichen zur Verfügung zu stellen.

Dieses Problem wird erfindungsgemäß gelöst durch ein Verfahren mit den Verfahrensschritten des unabhängigen Anspruchs 1.

Vorteilhafte Weiterbildungen sind Gegenstand abhängiger Unteransprüche.

Der Grundgedanke der Erfindung besteht darin, auf zumindest einem Teil der Oberfläche eines Halbleiterbauelementmaterials eine die Diffusion eines Dotierstoffes hemmende und für einen Dotierstoff durchdringbare Schicht auszubilden. Diese wird anschließend in wenigstens einem Hochdotierungsbereich zumindest teilweise entfernt. Im Weiteren wird eine Dotierstoffquelle auf der diffusionhemmenden Schicht und in dem wenigstens einen Hochdotierungsbereich ausgebildet. Aus dieser Dotierstoffquelle wird schließlich Dotierstoff in das Halbleiterbauelementmaterial eindiffundiert. Die diffusionhemmende Schicht wird dabei als poröse Schicht ausgebildet.

Bei dieser Diffusion gelangt Dotierstoff aus der in dem wenigstens einen Hochdotierungsbereich ausgebildeten Teil der Dotierstoffquelle vergleichsweise ungehindert in das Halbleiterbauelementmaterial hinein, da hier die diffusionhemmende Schicht wenigstens teilweise entfernt wurde. Nach einer gewissen Diffusionsdauer ist an diesen Stellen relativ viel Dotierstoff in das Halbleiterbauelementmaterial gelangt. In den Hochdotierungsbereichen liegt somit die erwünschte hohe Dotierung vor.

In denjenigen Bereichen hingegen, in welchen der Teil der oberfläche des Halbleiterbauelementmaterials unter der diffusionhemmenden Schicht liegt, gelangt nur wenig Dotierstoff in das Halbleiterbauelementmaterial. In Folge wird dieses in diesen Bereichen schwach dotiert. Der Schichtwiderstand in unter der nicht entfernten diffusionhemmenden Schicht gelegenen Bereichen des Teils der Oberfläche des Halbleiterbaumaterials kann dabei unter anderem durch die Dicke der diffusionhemmenden Schicht bestimmt werden.

Auf diese Weise können einfach und aufwandsgünstig Halbleiterbauelemente mit unterschiedlich stark dotierten Bereichen hergestellt werden, insbesondere ohne dass hierfür Maskierungsschritte notwendig wären, in welchen Teile der diffundierten Bereiche des Halbleiterbauelementmaterials vor einem Abätzen mittels eines gegenüber dem Ätzmedium inerten Material geschützt werden, und ohne dass mehrere Diffusionen durchzuführen währen.

Ein derartig gefertigtes Halbleiterbauelement kann erfindungsgemäß in integrierten Schaltkreisen oder elektronischen Schaltungen verwendet werden.

Darüber hinaus ist es Bestandteil der Erfindung, das erfindungsgemäße Verfahren zur Herstellung von Halbleiterbauelemente darstellenden Solarzellen mit selektiver Emitterstruktur zu verwenden.

Überdies sieht die Erfindung vor, wenigstens eine nach dem erfindungsgemäßen Verfahren hergestellte Solarzelle zur Herstellung von Solarzellenmodulen zu verwenden.

Beispielhafte Verfahren zur Erzeugung poröser,Schichten sind dem Grunde nach unter anderem beschrieben in Yerokhov, Melnyk et. al., Proceedings of the SPIE, Band 3580, 1998, Seiten 168-177.

Als Halbleiterbauelementmaterial kann grundsätzlich jedes Halbleitermaterial Verwendung finden, insbesondere Silizium oder Gallium oder deren Verbindungen. Auch die Verwendung von Verbindungshalbleitern ist selbstverständlich denkbar. In den meisten Anwendungsfällen weist das Halbleiterbauelementmaterial eine Grunddotierung auf. So kann bspw. p-dotiertes oder n-dotiertes Silizium Verwendung finden. Hierfür können bekannte Dotierstoffe wie Phosphor oder Bor eingesetzt werden. Die einzubringenden Dotierstoffe und die diesbezüglichen Dotierstoffquellen sind unter Berücksichtigung der Funktionsweise des Halbleiterbauelements auf die im Halbleiterbauelementmaterial vorherrschende Grunddotierung abzustimmen. So ist beispielsweise bei der Herstellung einer Solarzelle mit selektiver Emitterstruktur bei einem p-dotierten Solarzellenmaterial ein n-Dotierstoff wie z.B. Phosphor zu wählen.

Eine Weiterbildung des Verfahrens, die nicht Teil der beanspruchten Erfindung ist, sieht vor, dass die diffusionhemmende Schicht durch Aufspinnen und anschließende Trocknung, eine chemische Abscheidung aus der Dampfphase (CVD-Abscheidung) oder ein thermisches Aufwachsen in Ofenprozessen erfolgt. Solch ein thermisches Aufwachsen in einem Ofenprozess kann dabei beispielsweise in einem Ofen nach der Art eines aus der Halbleitertechnik bekannten Diffusionsofens erfolgen. Hierbei wird ein Stoff oder ein Stoffgemenge, gegebenenfalls unter Zuhilfenahme eines Trägergases durch ein Rohr des beheizten Ofens geleitet, wobei es mit in dem Rohr angeordneten Halbleiterbauelementmaterial derart in Wechselwirkung tritt, dass eine Anlagerung oder Abscheidung oder dergleichen der diffusionhemmenden Schicht auf dem Halbleiterbauelementmaterial eintritt.

Eine andere Ausgestaltungsvariante der Erfindung sieht vor, dass die diffusionhemmende Schicht in dem wenigstens einen Hochdotierungsbereich vollständig entfernt wird. Auf diese Weise kann an dieser Stelle ein besonders starker Dotierstoffeintrag erfolgen. Je nach Halbleiterbauelement und den zu dessen Herstellung weiter erforderlichen Schritten kann eine vollständige Entfernung der diffusionhemmenden Schicht jedoch auch nachteilig sein. So können beispielsweise bei mechanischem Abtrag oder bei Abtrag mittels eines Lasers, dem so genannten Ablationslaser, Schädigungen der Kristalloberfläche entstehen, welche eine erhöhte Ladungsträgerrekombination an diesen Stellen zur Folge haben. Diese wiederum kann die Funktion von Halbleiterbauelementen, beispielsweise Solarzellen, beeinträchtigen. Vor diesem Hintergrund kann es zweckmäßig erscheinen, die diffusionhemmende Schicht in dem wenigstens einen Hochdotierungsbereich nur teilweise zu entfernen und einen Rest stehen zu lassen. Dieser Rest vermag zwar die Diffusion zu behindern, doch fällt diese, bei entsprechender Auslegung der Schichtdicken und Diffusionszeiten, in den Hochdotierüngsbereichen dennoch deutlich stärker aus als in den übrigen, von einer diffusionhemmenden Schicht vollständiger Dicke bedeckten Bereichen.

Durch geeignete Technologien, beispielsweise einen Ablationslaser mit ausreichend hohem Energieeintrag, kann das Entfernen der diffusionhemmenden Schicht in Hochdotierungsbereichen gegebenenfalls auch ohne Schädigung der Kristalloberfläche erfolgen. In diesen Fällen kann auf das Verbleiben einer restlichen, dünnen diffusionhemmenden Schicht in den Hochdotierungsbereichen verzichtet werden.

Ein Ausführungsbeispiel der Erfindung sieht vor, dass das Halbleiterbauelement als Solarzelle ausgeführt wird, wobei zumindest ein Teil von Metallkontakten in den Hochdotierungsbereichen angeordnet wird, vorzugsweise Fingerkontakte. Dabei sind unter Fingerkontakten feingliedrige Kontakte zu verstehen, die der Einsammlung des generierten Stromes bei gleichzeitig geringstmöglicher Abschattung der aktiven Solarzellenfläche dienen.

Im Folgenden wird die Erfindung anhand von Figuren näher erläutert. Es zeigen:
- Figur 1:: Schematische Darstellung eines ersten Ausführungsbeispiels des erfindungsgemäßen Verfahrens
- Figur 2a:: Schematische Darstellung eines Verfahrens zur Herstellung einer Solarzelle mit selektiver Emitterstruktur als zweites Ausführungsbeispiel des erfindungsgemäßen Verfahrens. (Fortsetzung in Figur 2b)
- Figur 2b:: Fortsetzung des Verfahrens aus Figur 2a

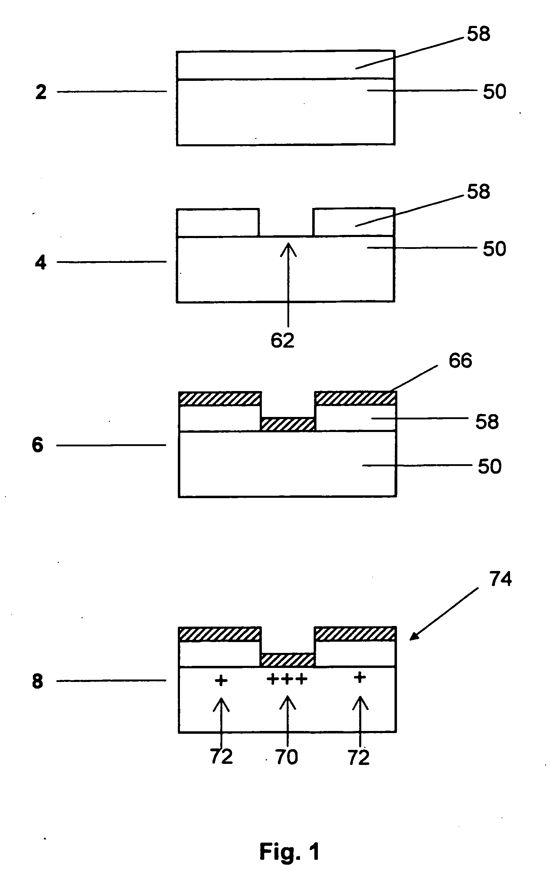

Figur 1 zeigt schematisch ein erstes Ausführungsbeispiel des Verfahrens gemäß der Erfindung. Hierin wird zunächst auf einer oberseitigen Oberfläche 56 eines Halbleiterbauelementmaterials 50 eine diffusionhemmende und für einen Dotierstoff durchdringbare Schicht 58 ausgebildet 2. Die diffusionshemmende Schicht 58 wird als poröse Schicht ausgebildet. Im Weiteren wird die diffusionhemmende Schicht 58 in wenigstens einem Hochdotierungsbereich 62 vollständig entfernt 4.

Es folgt das Ausbilden 6 einer Dotierstoffquelle 66, aus welcher unter bestimmten Bedingungen ein Dotierstoff heraus diffundiert. Die Dotierstoffquelle 66 wird dabei auf der diffusionhemmenden Schicht 58 wie auch in dem Hochdotierungsbereich 62 aufgebracht. Im letzteren Fall kommt sie aufgrund der vollständigen Entfernung der diffusionhemmenden Schicht 58 in diesem Bereich direkt auf der oberseitigen Oberfläche 56 des Halbleiterbauelementmaterials 50 zu liegen. Bei der Dotierstoffquelle 66 kann es sich beispielsweise um ein Phosphorglas handeln. Daneben ist jedoch prinzipiell jede andere Dotierstoffquelle denkbar.

Aus der Dotierstoffquelle 66 wird im Folgenden Dotierstoff aus- und in die oberseitige Oberfläche 56 des Halbleiterbauelementmaterials 50 eindiffundiert 8. Dies erfolgt in den meisten Fällen durch thermische Energiezufuhr. Im Falle der von der diffusionhemmenden Schicht 58 bedeckten Bereichen der oberseitigen Oberfläche 56 des Halbleiterbauelementmaterials 50 bewegt sich hierbei Dotierstoff durch die diffusionhemmende Schicht, wodurch nur ein gewisser Anteil des in der Dotierstoffquelle 66 freigesetzten Dotierstoffes in das Halbleiterbauelementmaterial gelangen kann.

Im Hochdotierungsbereich 62 hingegen gelangt der Dotierstoff ungehindert in die oberseitige Oberfläche 56 des Halberbauelementmaterials. Infolgedessen stellt sich in der Umgebung der Hochdotierungsbereichs 62 in der oberseitigen Oberfläche 56 des Halbleiterbauelementmaterials eine starke Dotierung 70 ein, wogegen in den unter der diffusionhemmenden Schicht 58 gelegenen Bereichen der oberseitigen Oberfläche 56 eine schwache Dotierung 72 resultiert.

Somit ergibt sich auf einfache Weise ein Halbleiterbauelement mit unterschiedlich stark dotierten Bereichen.

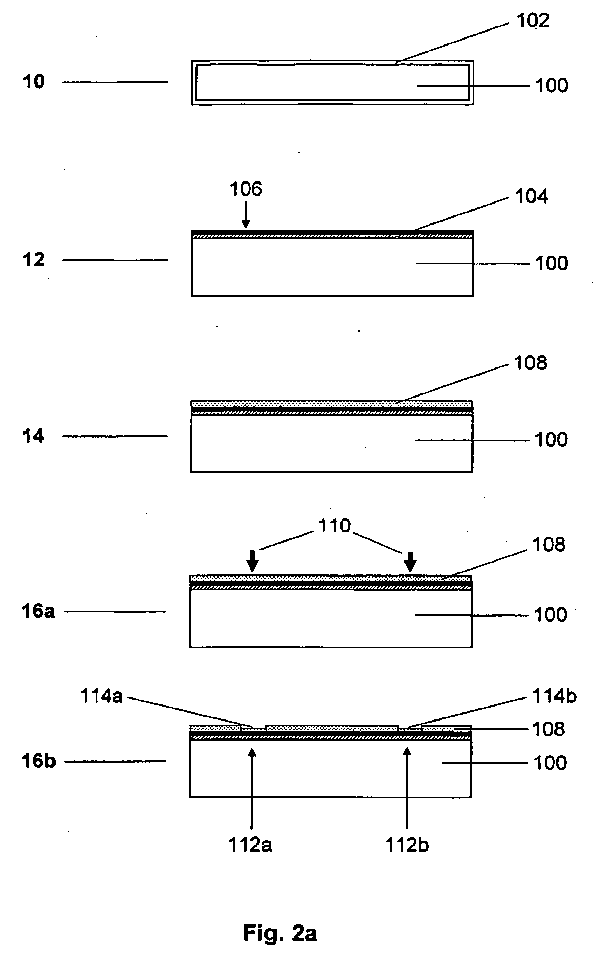

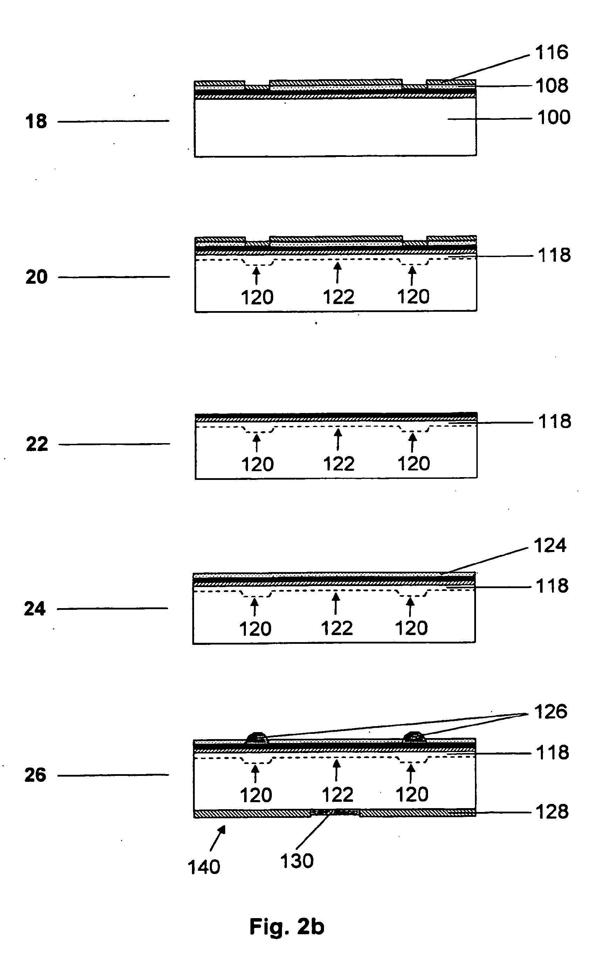

Die Figuren 2a und 2b zeigen ein Verfahren zur Herstellung einer Solarzelle mit selektiver Emitterstruktur als weiteres Ausführungsbeispiel des erfindungsgemäßen Verfahrens. Den Ausgangspunkt des Verfahrens bildet das Bereitstellen 10 des Ausgangssolarzellenmaterials, was im vorliegenden Ausführungsbeispiel durch p-dotiertes Solarzellenmaterial, insbesondere Silizium, gebildet wird. In analoger Weise könnte auch n-dotiertes Solarzellenmaterial den Ausgangspunkt bilden. Die verwendeten Dotierstoffe und Dotierstoffquelle wären sodann entsprechend angepasst zu wählen.

Im schematisch dargestellten Fall der Figur 2a weist das Solarzellenmaterial 100 einen Sägeschaden 102 auf, wie er üblicherweise bei Halbleiterscheiben vorkommt, die von einem gegossenen Block bzw. einem gezogenen ingot durch Sägen abgetrennt wurden. Dieser Sägeschaden wird zunächst entfernt 12, was üblicherweise durch Überätzen der Siliziumscheibe bzw. des Solarzellenmaterials 100 geschieht, und eine Textur 104 in die oberseitige Oberfläche 106 des Solarzellenmaterials 100 eingebracht 12. Die Textur 104 kann dabei unter Ausnutzung bekannter Verfahren wie chemische oder mechanische Texturierung realisiert werden.

Die diffusionhemmende Schicht wird in Form einer porösen Schicht 108 aus Solarzellenmaterial 100 ausgebildet 14. Im Falle von Silizium als Solarzellenmaterial kann dies beispielsweise mittels einer Atzlösung erfolgen, welche Flusssäure (HF), Salpetersäure (HNO₃) und Wasser (H₂O) enthält, vorzugsweise in einem Mischungsverhältnis von HF : HNO₃ : H₂O im Bereich von 100 : 1 bis 2 : 5 bis 10. Dabei wird die poröse Schicht 108 in einer Dicke von weniger als 200 nm ausgebildet, bevorzugt in einer Dicke im Bereich von 80 bis 120 nm.

Hernach wird Ablationslaserlicht 110 in Hochdotierungsbereichen 112a, 112b appliziert 16a. Unter diesem Energieeintrag verdampft in den Hochdotierungsbereichen die poröse Schicht 108, wobei diese jedoch im vorliegenden Ausführungsbeispiel jedoch nur teilweise entfernt wird 16b, so dass ein Rest 114a, 114b der porösen Schicht 108 bestehen bleibt. Auf diese Weise wird ausgeschlossen, dass die Oberfläche des Solarzellenmaterials 100, geschädigt wird und in den Hochdotierungsbereichen 112a, 112b eine Erhöhung der Ladungsträgerrekombination erfolgt.

Im Weiteren wird eine Dotierstoffquelle ausgebildet. Da es sich bei dem Solarzellenmaterial um p-dotiertes Material handelt, wird vorliegend Phosphor als gängigster n-Dotierstoff verwendet. Es können aber auch andere Dotierstoffe verwendet werden. Die Dotierstoffquelle wird in diesem Ausführungsbeispiel als Phosphorglas 116 ausgebildet. Dies kann beispielsweise in einem Ofenprozess erfolgen, in welchem das Solarzellenmaterial einem POCl₃-Strom, gegebenenfalls ergänzt um ein Trägergas, ausgesetzt wird. Daneben Phosphor auch in anderer Weise in einer Dotierstoffquelle zur Verfügung gestellt werden, beispielsweise durch Aufspinnen und anschließendes Trocknen einer phosphorhaltigen Paste oder Lösung oder durch chemische oder physikalische Abscheidung von phosphorhaltigen Verbindungen.

Sodann erfolgt die Diffusion 20 des Phosphors aus dem Phosphorglas, oder gegebenenfalls anderen Dotierstoffquellen, in das Solarzellenmaterial. Dabei ist die Diffusion aus dem Phosphorglas 116 in die oberseitige Oberfläche 106 des Solarzellenmaterials 100 durch die poröse Schicht aus Solarzellenmaterial 108 gehemmt. Da in diesem Ausführungsbeispiel auch in den Hochdotierungsbereichen 112a, 112b noch poröses Siliziummaterial vorliegt, ist auch hier die Diffusion gehemmt. Allerdings deutlich geringer als in denjenigen Bereichen, in denen die poröse Schicht 108 nach wie vor in ihrer gesamten Dicke vorliegt. Da in den Hochdotierungsbereichen 112a, 112b nur ein geringer Rest 114a, 114b der porösen Schicht 108 vorliegt, kann somit in diesen Bereichen in gleicher Zeit deutlich mehr Dotierstoff in die oberseitige Oberfläche 106 des Solarzellenmaterials gelangen. Infolgedessen werden hier niederohmige Emitterbereiche 120 ausgebildet. Im Übrigen werden hochohmige Emitterbereiche 122 ausgebildet. In der Summe ergibt sich eine Emitterstruktur 118 mit hochohmigen 122 und niederohmigen 120 Bereichen, die üblicherweise als selektiver Emitter bezeichnet wird.

Nach der Diffusion 20 haben die poröse Schicht 108 wie auch das als Dotierstoffquelle wirkende Phosphorglas 116 ihren Zweck erfüllt und werden gemeinsam entfernt 22. Dies erfolgt bevorzugt in einem gemeinsamen Ätzschritt.

Im Weiteren wird eine Antireflexionsbeschichtung 124 aufgebracht 24, wobei dieser Verfahrensschritt ein Beispiel nütchich für das verständnis der Erfindung ist. Danach folgt das Ausbilden 26 von Metallkontakten 126,128, 130 auf der Vorderseite der Solarzelle 140 sowie auf deren Rückseite. Im vorliegenden Ausführungsbeispiel werden dabei die Metallkontakte 126 der Vorderseite auf den niederohmigen Bereichen 120 der Emitterstruktur 118 angeordnet. Auf diese Weise kann ein geringer Kontaktwiderstand zwischen der Emitterstruktur 118 und den Metallkontakten 126 gewährleistet werden, wogegen in den übrigen Bereichen ein geringe Ladungsträgerrekombination aufgrund der hochohmigen Emitterbereiche 122 vorliegt. Typische Schichtwiderstandswerte für niederohmige Emitterbereiche 120 liegen bei etwa 10 bis 30 Ω/square, für hochohmige Emitterbereiche 122 bei etwa 80 bis 140 Ω/square.

Die folgenden verfahrenschritte sindnütchich für das Verstandnis Erfindung:
Auf der Rückseite wird zur Verbesserung der Konversionseffizienz ein an sich bekanntes back-surface-field aufgebracht, welches vorliegend aus einer flächigen Rückseitenmetallisierung aus Aluminium besteht. Dieses wird durchsetzt von wenigstens einem lokalen rückseitigen Metallkontakt 130, welcher die Kontaktierung des p-dotierten Solarzellenmaterials 100 bewerkstelligt.

Das erfindungsgemäße Verfahren lässt sich offensichtlich auch auf andere Solarzellenkonzepte als das in Verbindung mit den Figuren 2a und 2b beschriebene übertragen. Insbesondere kann es bei Bifacialzellen, bei welchen sowohl die Vorder- als auch die Rückseite der Solarzelle für die Stromgeneration genutzt werden, wie auch bei vollständig rückseitig kontaktierten Solarzellen Verwendung finden.

### Bezugszeichenliste

- 2: Ausbilden diffusionhemmende Schicht
- 4: vollständiges Entfernen der diffusionhemmenden Schicht in Hochdotierungsbereich
- 6: Ausbilden Dotierstoffquelle
- 8: Diffundieren des Dotierstoffes aus Dotierstoffquelle in Halbleiterbauelementmaterial
- 10: Bereitstellen des Ausgangssolarzellenmaterials
- 12: Entfernen des Sägeschadens und Texturierung der Oberfläche des Solarzellenmaterials
- 14: Ausbilden einer porösen Schicht aus Solarzellenmaterial
- 16a: Applizieren von Ablationslaserlicht
- 16b: teilweises Entfernen der porösen Schicht in Hochdotierungsbereichen
- 18: Ausbilden von Phosphorglas als Dotierstoffquelle
- 20: Diffundieren des Phosphors aus dem Phosphorglas in das Solarzellenmaterial
- 22: Gemeinsames Entfernen des Phosphorglases und der porösen Schicht
- 24: Aufbringen einer Antireflexionsbeschichtung
- 26: Ausbilden von Metallkontakten auf der Vorder- und Rückseite
- 50: Halbleiterbauelementmaterial
- 56: oberseitige Oberfläche des Halbleiterbauelementmaterials
- 58: diffusionhemmende Schicht
- 62: Hochdotierungsbereich
- 66: Dotierstoffquelle
- 70: stark dotierter Bereich
- 72: schwach dotierter Bereich
- 74: Halbleiterbauelement
- 100: p-dotiertes Solarzellenmaterial
- 102: Sägeschaden
- 104: Textur
- 106: oberseitige Oberfläche des Solarzellenmaterials
- 108: poröse Schicht aus Solarzellenmaterial
- 110: Ablationslaserlicht
- 112a: Hochdotierungsbereich
- 112b: Hochdotierungsbereich
- 114a: Rest der porösen Schicht
- 114b: Rest der porösen Schicht
- 116: Phosphorglas
- 118: Selektive Emitterstruktur
- 120: niederohmiger Emitterbereich
- 122: hochohmiger Emitterbereich
- 124: Antireflexionsbeschichtung
- 126: Metallkontakte auf der Vorderseite
- 128: flächige Rückseitenmetallisierung
- 130: lokaler Metallkontakt auf der Rückseite
- 140: Solarzelle

## Patentansprüche

1. Verfahren zur Herstellung eines Halbleiterbauelements (74;140) mit unterschiedlich stark dotierten Bereichen (70,72; 120, 122) aufweisend die Verfahrensschritte
- des Ausbildens (2; 14) einer die Diffusion eines Dotierstoffes hemmenden und für diesen Dotierstoff durchdringbaren Schicht (58; 108) auf zumindest einem Teil (56; 106) einer Oberfläche eines Halbleiterbauelementmaterials (50; 100);
- des wenigstens teilweisen Entfernens (4; 16a, 16b) der diffusionhemmenden Schicht (58; 108) in werigstens einem Hochdotierungsbereich (62; 112a, 112b);
- des Ausbildens (6; 18) einer Dotierstoffquelle (66; 116) auf der diffusionhemmenden Schicht (58; 108) und in dem wenigstens einen Hochdotierungsbereich (62; 112a, 112b);
- der Diffusion (8; 20) des Dotierstoffes aus der Dotierstoffquelle (66; 116) in das Halbleiterbauelementmaterial (50; 100), bei welcher der Dotierstoff durch die diffusionheircaende Schicht (58; 108) diffundiert wird, sodass in unter der diffusionhemmenden Schicht (58; 108) gelegenen Bereichen (72; 122) der Oberfläche des Halbleiterbauelementmaterials (50; 100) eine schwache Dotierung resultiert, und bei welcher in dem wenigstens einen Hochdotierungsbereich (62; 112a, 112b) der Dotierstoff in das Halbleiterbauelementmaterials (50; 100) diffundiert wird, sodass sich in dem wenigstens einen Hochdotierungsbereich (62; 112a, 112b) in der Oberfläche des Halbleiterbauelementmaterials (50; 100) eine starke Dotierung (70; 120) einstellt; wobei
als diffusionhemmende Schicht (108) eine poröse Schicht (103) ausgebildet wird.

2. Verfahren Anspruch 1,
**dadurch gekennzeichnet, dass** die poröse Schicht (108) aus Halbleiterbauelementmaterial (100) ausgebildet wird.

3. Verfahren nach einem der Ansprüche 1 bis 2,
**dadurch gekennzeichnet, dass** die poröse Schicht (108) in einer Dicke von weniger als 200 nm ausgebildet wird, vorzugsweise in einer Dicke im Bereich von 80 bis 120 nm.

4. Verfahren nach einem der Ansprüche 2 bis 3,
**dadurch gekennzeichnet, dass** zur Ausbildung der porösen Schicht (108) aus Halbleiterbauelementmaterial (100) wenigstens der Teil (106) der Oberfläche des Halbleiterbauelements einer Ätzlösung ausgesetzt wird.

5. Verfahren nach Anspruch 4,
**dadurch gekennzeichnet, dass** die Atzlösung Flusssäure (HF), Salpetersäure (HNO₃) und Wasser (H₂O) enthält, vorzugsweise in einem Mischungsverhältnis von HF : HNO₃ : H₂O im Bereich von 100 : 1 bis 2 : 5 bis 10.

6. Verfahren nach einem der Ansprüche 2 bis 3,
**dadurch gekennzeichnet, dass** zur Ausbildung der porösen Schicht (108) aus Halbleiterbauelementmaterial (100) wenigstens der Teil (106) der Oberfläche des Halbleiterbauelements einem ätzenden Plasma ausgesetzt wird.

7. Verfahren nach einem der Ansprüche 1 bis 6,
**dadurch gekennzeichnet, dass** das wenigstens teilweise Entfernen (4; 16a, 16b) der diffusionhemmenden Schicht (58; 108) in dem wenigstens einen Hochdotierungsbereich (62; 112a, 112b) mittels Ablationslaserlicht (110) erfolgt, vorzugsweise mittels Licht eines frequenzverdoppelten oder frequenzverdreifachten Ablationslasers.

8. Verfahren nach einem der Ansprüche 1 bis 7,
**dadurch gekennzeichnet, dass** das wenigstens teilweise Entfernen (4; 16b) der diffusionhemmenden Schicht (58; 108) in dem wenigstens einen Hochdotierungsbereich (62; 112a, 112b) mittels einer ätzenden Paste, vorzugsweise einer Flusssäure enthaltenden Paste erfolgt.

9. Verfahren nach Anspruch 8,
**dadurch gekennzeichnet, dass** die ätzende Paste mittels einer Druck- oder Spritztechnik auf den wenigstens einen Hochdotierungsbereich (62; 112a, 112b) aufgebracht wird, vorzugsweise mittels ainer Siebdruck-, Stempeldruck-, Spritzendruck- oder Rollendrucktechnik.

10. Verfahren nach einem der Ansprüche 1 bis 9,
**dadurch gekennzeichnet, dass** nach der Diffusion (8; 20) des Dotierstoffes aus der Dotierstoffquelle (66; 116) in den Teil (56; 106) der Oberfläche des Halbleiterbauelementmaterials (50; 100) die Dotierstoffquelle (66; 116) zusammen mit der diffusionhemmenden Schicht (58; 108) entfernt wird.

11. Verfahren nach einem der Ansprüche 1 bis 10,
**dadurch gekennzeichnet, dass** das Halbleiterbauelement als Solarzelle (140) ausgeführt wird, wobei zumindest ein Teil von Metallkontakten (126), vorzugsweise Fingerkontakte, in Hochdotierungsbereichen (112a, 112b) angeordnet wird.

12. Verfahren nach Anspruch 11,
**dadurch gekennzeichnet, dass** sowohl auf der Vorderseite der Solarzelle wie auch auf deren Rückseite Hochdotierungsbereiche (112a, 112b) vorgesehen werden.

13. Verfahren nach einem der Ansprüche 11 bis 12,
**dadurch gekennzeichnet, dass** die Dotierstoffquelle (66; 116) aus Phosphorglas (116) gebildet wird, als diffusionhemmende Schicht (58; 108) poröses Solarzellenmaterial (108) verwendet wird und das Phosphorglas (116) zusammen mit der Schicht porösen Solarzellenmaterials (108) durch Ätzen in einer Ätzlösung oder einem Plasma entfernt wird.

14. Verfahren nach einem der Ansprüche 11 bis 13,
**dadurch gekennzeichnet, dass** die Hochdotierungsbereiche (62; 112a, 112b) breiter ausgeführt werden als die später in diesen Bereichen aufgebrachte Metallisierung (126).

15. Verfahren nach einem der Ansprüche 11 bis 14,
**dadurch gekennzeichnet ,**
**dass** eine Solarzelle (140) mit selektiver Emitterstruktur (118) hergestellt wird.

## Claims

1. A method for producing a semiconductor device (74; 140) having regions (70, 72; 120, 122) which are doped to different extents, said method having the method steps of
- forming (2; 14) a layer (58; 108), which inhibits the diffusion of a dopant and can be penetrated by this dopant, on at least one part (56; 106) of a surface of a semiconductor device material (50; 100);
- at least partially removing (4; 16a, 16b) the diffusion-inhibiting layer (58; 108) in at least one high-doping region (62; 112a, 112b);
- forming (6; 18) a dopant source (66; 116) on the diffusion-inhibiting layer (58; 108) and in the at least one high-doping region (62; 112a, 112b);
- diffusing (8; 20) the dopant from the dopant source (66; 116) into the semiconductor device material (50; 100), during which the dopant is diffused through the diffusion-inhibiting layer (58; 108) such that a weak doping results in regions (72; 122) of the surface of the semiconductor device material (50; 100) that are located underneath the diffusion-inhibiting layer (58; 100), and during which the dopant is diffused into the semiconductor device material (50; 100) in the at least one high-doping region (62; 112a, 112b) such that in the at least one high-doping region (62; 112a, 112b) a heavy doping (70; 120) arises in the surface of the semiconductor device material (50; 100);
wherein a porous layer (108) is formed as the diffusion-inhibiting layer (108).

2. The method according to claim 1, **characterized in that** the porous layer (108) is formed from semiconductor device material (100).

3. The method according to any of claims 1 to 2, **characterized in that** the porous layer (108) is formed in a thickness of less than 200 nm, preferably in a thickness in the range of from 80 to 120 nm.

4. The method according to any of claims 2 to 3, **characterized in that** in order to form the porous layer (108) from semiconductor device material (100), at least the part (106) of the surface of the semiconductor device is exposed to an etching solution.

5. The method according to claim 4, **characterized in that** the etching solution contains hydrofluoric acid (HF), nitric acid (HNO₃) and water (H₂O), preferably in a mixing ratio of HF : HNO₃ : H₂O in the range of from 100 : 1 to 2 : 5 to 10.

6. The method according to any of claims 2 to 3, **characterized in that** in order to form the porous layer (108) from semiconductor device material (100), at least the part (106) of the surface of the semiconductor device is exposed to an etching plasma.

7. The method according to any of claims 1 to 6, **characterized in that** the diffusion-inhibiting layer (58; 108) is at least partially removed (4; 16a, 16b) in the at least one high-doping region (62; 112a, 112b) using ablation laser light (110), preferably using light from a frequency-doubled or frequency-tripled ablation laser.

8. The method according to any of claims 1 to 7, **characterized in that** the diffusion-inhibiting layer (58; 108) is at least partially removed (4; 16b) in the at least one high-doping region (62; 112a, 112b) using an etching paste, preferably a paste which contains hydrofluoric acid.

9. The method according to 8, **characterized in that** the etching paste is applied to the at least one high-doping region (62; 112a, 112b) using a printing or injection-molding technology, preferably using a screen-printing, stamp-printing, spray-printing or web-printing technology.

10. The method according to any of claims 1 to 9, **characterised in that** after the dopant has been diffused (8; 20) from the dopant source (66; 116) into the part (56; 106) of the surface of the semiconductor device material (50; 100), the dopant source (66; 116) is removed together with the diffusion-inhibiting layer (58; 108).

11. The method according to any of claims 1 to 10, **characterized in that** the semiconductor device is in the form of a solar cell (140), at least some metal contacts (126), preferably finger contacts, being arranged in high-doping regions (112a, 112b).

12. The method according to claim 11, **characterized in that** high-doping regions (112a, 112b) are provided both on the front side of the solar cell and on the rear side of the latter.

13. The method according to any of claims 11 to 12, **characterized in that** the dopant source (66; 116) is formed from phosphorus glass (116), porous solar cell material (108) is used as diffusion-inhibiting layer (58; 108) and the phosphorus glass (116) is removed together with the layer of porous solar cell material (108) by means of etching in an etching solution or a plasma.

14. The method according to any of claims 11 to 13, **characterized in that** the high-doping regions (62; 112a, 112b) are broader than the metallization (126) subsequently applied in these regions.

15. The method as claimed in one of claims 11 to 14, **characterized in that** a solar cell (140) having a selective emitter structure (118) is produced.

## Revendications

1. Procédé pour la fabrication d'un composant semi-conducteur (74; 140) avec des zones de différent dopage (70, 72; 120, 122) qui présente les étapes de procédé
- de formation (2; 14) d'une couche (58; 108) qui empêche la diffusion d'un dopant et qui est perméable pour ce dopant sur au moins une partie (56; 106) d'une surface d'un matériau de composant semi-conducteur (50; 100);
- d'enlèvement au moins partiel (4; 16a, 16b) de la couche inhibitrice de diffusion (58; 108) dans au moins une zone de dopage élevé (62; 112a, 112b);
- de formation (6; 18) d'une source de dopant (66; 116) sur la couche inhibitrice de diffusion (58; 108) et dans la zone de dopage élevé (62; 112a, 112b) qui existe au moins;
- de diffusion (8; 20) du dopant à partir de la source de dopant (66; 116) dans le matériau du composant semi-conducteur (50; 100), lors de laquelle le dopant est diffusé par la couche inhibitrice de diffusion (58; 108), si bien qu'il résulte un faible dopage dans des zones (72; 122) de la surface du matériau du composant semi-conducteur (50; 100) qui sont situées sous la couche inhibitrice de diffusion (58; 108) et lors de laquelle le dopant est diffusé dans le matériau du composant semi-conducteur (50; 100) dans la zone de dopage élevé (62; 112a, 112b) qui existe au moins si bien qu'un dopage élevé (70; 120) se règle dans la surface du matériau du composant semi-conducteur (50; 100) dans la zone de dopage élevé (62; 112a, 112b) qui existe au moins,
une couche poreuse (108) étant formée comme couche inhibitrice de diffusion (108).

2. Procédé selon la revendication 1, **caractérisé en ce que** la couche poreuse (108) est formée comme le matériau du composant semi-conducteur (100).

3. Procédé selon l'une des revendications 1 à 2, **caractérisé en ce que** la couche poreuse (108) est formée dans une épaisseur de moins de 200 nm, de préférence dans une épaisseur de l'ordre de 90 à 120 nm.

4. Procédé selon l'une des revendications 2 à 3, **caractérisé en ce que**, pour la formation de la couche poreuse (108) en matériau du composant semi-conducteur (100), au moins la partie (106) de la surface du matériau du composant semi-conducteur est exposée à une solution d'attaque.

5. Procédé selon la revendication 4, **caraatérisé en ce** que la solution d'attaque contient de l'acide fluorhydrique (HF), de l'acide azotique (HN0₃) et de l'eau (H₂₀), de préférence dans un rapport de mélange de HF : HN0₃ : H₂0 de l'ordre de 100 : 1 à 2 : 5 à 10.

6. Procédé selon l'une des revendications 2 à 3, **caractérisé en ce que**, pour la formation de la couche poreuse (108) de matériau du composant semi-conducteur (100), au moins la partie (106) de la surface du composant semi-conducteur est exposée à un plasma d'attaque.

7. Procédé selon l'une des revendications 1 à 6, **caractérisé en ce que** l'enlèvement au moins partiel (4; 16a, 16b) de la couche inhibitrice de diffusion (58; 108) se fait dans la zone de dopage élevé (62; 112a, 112b) qui existe au moins au moyen d'une lumière au laser ablatif (110), de préférence au moyen de la lumière d'un laser ablatif à fréquence doublée ou triplée.

8. Procédé selon l'une des revendications 1 à 7, **caractérisé en ce que** l'enlèvement au moins partiel (4; 16b) de la couche inhibitrice de diffusion (58; 108) se fait dans la zone de dopage élevé (62; 112a, 112b) qui existe au moins au moyen d'une pâte mordante, de préférence d'une pâte qui contient un acide fluorhydrique.

9. Procédé selon la revendication 8, **caractérisé en ce que** la pâte mordante est appliquée au moyen d'une technique d'impression ou d'injection sur la zone de dopage élevé (62; 112a, 112b) qui existe au moins, de préférence au moyen d'une technique de sérigraphie, de timbrage, d'une technique d'impression par injection ou une technique d'impression par rotative.

10. Procédé selon l'une des revendications 1 à 9, **caractérisé en ce qu'**après la diffusion (8; 20) du dopant à partir de la source de dopant (66; 116) dans la partie (56; 106) de la surface du matériau du composant semi-conducteur (50; 100) la source de dopant (66; 116) est enlevée en même temps que la couche inhibitrice de diffusion (58 ; 108).

11. Procédé selon l'une des revendications 1 à 10, **caractérisé en ce que** le composant semi-conducteur est réalisé comme une cellule solaire (140), au moins une partie des contacts métalliques (126), de préférence les doigts de contact, étant placés dans des zones de dopage élevé (112a, 112b).

12. Procédé selon la revendication 11, **caractérisé en ce qu'**il est prévu des zones de dopage élevé (112a, 112b) aussi bien sur la face avant que sur la face arrière de la cellule solaire.

13. Procédé selon l'une des revendications 11 à 12, **caractérisé en ce que** la source de dopant (66; 166) est formée par du verre au phosphore (116), que du matériau de cellule solaire poreux (108) est utilisé comme couche inhibitrice de diffusion (58 ; 108) et que le verre au phosphore (116) est enlevé avec la couche de matériau de cellule solaire poreux (108) par mordançage dans une solution d'attaque ou un plasma.

14. Procédé selon l'une des revendications 11 à 13, **caractérisé en ce que** les zones de dopage élevé (62; 112a, 112b) sont réalisées plus larges que la métallisation (126) appliquée plus tard dans ces zones.

15. Procédé selon l'une des revendications 11 à 14, **caractérisé en ce qu'**une cellule solaire (140) est fabriquée avec une structure à émetteur sélectif (118).
